# EUROPÄISCHE PATENTANMELDUNG

(11) **EP 4 223 109 A1**
(43) Veröffentlichungstag der Anmeldung: **09.08.2023**
(21) Anmeldenummer: 23154178.0
(22) Anmeldetag: 31.01.2023
(51) Int. Cl.: A01K 1/00, F24F 12/00, H10N 10/13

(54) **STROMERZEUGUNGSANLAGE ZUR ABWÄRMENUTZUNG**

(30) Priorität: 01.02.2022 AT 5001322 U
(71) Anmelder: Schauer Agrotronic GmbH, 4731 Prambachkirchen (AT)
(72) Erfinder: SCHÖNBAUER, Hubert, 4722 Peuerbach (AT)
(74) Vertreter: Burger, Hannes

(57) **Zusammenfassung**

Die Erfindung betrifft eine Stromerzeugungsanlage (1) zur Abwärmenutzung einer Tierstallung (6) umfassend einen Frischluftraum (2) und einen Abluftkanal (10), der Abluftkanal (10) umfassend einen Einlassbereich (9) und einen Energieaustauscher-Bereich (12), wobei mittels dem Einlassbereich (9) des Abluftkanals (10) ein Abluftstrom (8) aus der Tierstallung (6) entnehmbar ist und über den Energieaustauscher-Bereich (12) in eine äußere Umgebung abführbar ist. Der Energieaustauscher-Bereich (12) des Abluftkanals (10) ist im Frischluftraum (2) angeordnet ist, wobei ein Zuluftstrom (5) über den Frischluftraum (2) mittels Zuluftkanälen (3) in die Tierstallung (6) einbringbar ist. Der Abluftkanal (10) umfasst im Energieaustauscher-Bereich (12) einen thermoelektrischen Generator (11), welcher thermoelektrische Generator (11) eine wärmeleitfähige Wandung (16) und eine Thermoelektrizitäts-Modulanordnung, insbesondere eine Seebeck-Effekt-Modul-Anordnung (13), umfasst, welche einzelne Seebeck-Effekt-Module (14) umfasst, mittels welcher Seebeck-Effekt-Module (14) durch eine Temperaturdifferenz zwischen dem Zuluftstrom (5) und dem Abluftstrom (8) elektrische Energie generierbar ist.

## Beschreibung

Die Erfindung betrifft eine Stromerzeugungsanlage zur Abwärmenutzung einer Tierstallung mittels eines thermoelektrischen Generators, wobei mittels einer Thermoelektrizitäts-Modulanordnung, insbesondere einer Seebeck-Effekt-Modul-Anordnung, auf Grund einer Temperaturdifferenz zwischen einem Zuluftstrom zur Tierstallung und einem Abluftstrom aus der Tierstallung elektrische Energie generierbar ist.

Aus der EP2378578B 1 ist ein Wärmeübertrager für eine Abgasanlage bekannt geworden, wobei zwischen einem Warmrohr und einem Kaltrohr ein thermoelektrischer Generator angeordnet ist, welcher zum Erzeugen von elektrischer Energie aus einer Temperaturdifferenz dient. Der aus dem Dokument bekannte Wärmeübertrager weist den Nachteil auf, dass damit eine Temperaturdifferenz zwischen dem Zuluftstrom und dem Abluftstrom einer Tierstallung nur eingeschränkt bzw. nicht effektiv genutzt werden kann, da die Temperaturdifferenz nicht dem Niveau wie bei einer Brennkraftmaschine entspricht.

Aufgabe der vorliegenden Erfindung war es, die Nachteile des Standes der Technik zu überwinden und eine Vorrichtung zur Verfügung zu stellen, mittels derer eine Abwärmenutzung einer Tierstallung realisiert werden kann.

Diese Aufgabe wird durch eine Vorrichtung und ein Verfahren gemäß den Ansprüchen gelöst.

Die erfindungsgemäße Stromerzeugungsanlage zur Abwärmenutzung einer Tierstallung umfasst einen Frischluftraum und einen Abluftkanal. Der Abluftkanal umfasst einen Einlassbereich und einen Energieaustauscher-Bereich, wobei mittels dem Einlassbereich des Abluftkanals ein Abluftstrom aus der Tierstallung entnehmbar ist und über den Energieaustauscher-Bereich in eine äußere Umgebung abführbar ist. Der Energieaustauscher-Bereich des Abluftkanals ist im Frischluftraum angeordnet ist, wobei ein Zuluftstrom über den Frischluftraum mittels Zuluftkanäle in die Tierstallung einbringbar ist. Der Abluftkanal umfasst im Energieaustauscher-Bereich einen thermoelektrischen Generator, welcher thermoelektrische Generator eine wärmeleitfähige Wandung und eine Thermoelektrizitäts-Modulanordnung, insbesondere eine Seebeck-Effekt-Modul-Anordnung, umfasst. Die Seebeck-Effekt-Modul-Anordnung umfasst einzelne Seebeck-Effekt-Module, mittels welcher Seebeck-Effekt-Module durch eine Temperaturdifferenz zwischen dem Zuluftstrom und dem Abluftstrom elektrische Energie generierbar ist.

Der thermoelektrische Generator kann Seebeck-Effekt-Module, Wärmetauscher-Elemente, Verbindungskabel, Steuerungsverbindungen sowie weitere elektronische Bauteile, wie beispielsweise Transistoren, Kondensatoren, Leiterplatten, Steuereinheiten, usw. umfassen. Die Seebeck-Effekt-Module können zu Seebeck-Effekt-Modul-Anordnungen elektrisch verbunden sein. Die wärmeleitfähige Wandung des thermoelektrischen Generators ist mit den Seebeck-Effekt-Modulen in wärmeleitender Verbindung. Ein Seebeck-Effekt-Modul kann eine erste Platte und eine zweite Platte aufweisen, zwischen welchen beiden Platten n-dotierte und p-dotierte Halbleiter derart angeordnet sind, dass mittels einer Temperaturdifferenz zwischen der Temperatur der ersten Platte und der zweiten Platte vom Seebeck-Effekt-Modul durch den physikalischen Seebeck-Effekt eine Thermospannung generiert wird. Durch die erfindungsgemäße Anordnung der Seebeck-Effekt-Modul-Anordnung wird die Möglichkeit geschaffen, dass eine Temperaturdifferenz zwischen einem Zuluftstrom und einem Abluftstrom nutzbar ist. Vorteilhaft ist dabei, dass im Vergleich zu thermodynamischen Kreisprozessen geringere Temperaturdifferenzen im Bereich von 5K bis 65K mit der erfindungsgemäßen Anordnung noch nutzbar sind. Damit ist die Möglichkeit geschaffen, dass beispielsweise die Abwärme einer Kühlanlage, von Serverräumen, Niedertemperatur-Chemie, Heizkaminen oder Tierstallungen genützt werden kann, um thermoelektrisch Strom zu generieren. Vorteilhaft ist weiters, dass die erfindungsgemäße Anordnung keine beweglichen Teile aufweist und dass die Herstellbarkeit der Seebeck-Effekt-Module durch gängige Metalldruckverfahren kostengünstig möglich ist.

Die Seebeck-Effekt-Modul-Anordnung kann mehrere Seebeck-Effekt-Module umfassen, welche parallel oder seriell elektrische miteinander verbunden sein können. Damit kann die Spannung und die Stromstärke der Seebeck-Effekt-Modul-Anordnung beeinflusst werden. Eine Seebeck-Effekt-Modul-Anordnung kann im Energieaustauscher-Bereich des Abluftkanals entlang der Umfangsrichtung angeordnet sein oder in Richtung der Strömung des Abluftstroms angeordnet sein.

Gemäß einer Weiterbildung ist es möglich, dass in einer Zuluftdecke Zuluftkanäle ausgebildet sind, wobei mittels der Zuluftkanäle aus dem Frischluftraum oder aus einem Frischluftkanal der Zuluftstrom in die Tierstallung einbringbar ist. Vorteilhaft ist dabei, dass eine gleichmäßige Verteilung des Zuluftstroms in der Tierstallung bewirkt wird, wodurch die Wärmeaufnahme des Luftstroms verbessert ist. Damit kann in weiterer Folge die Temperaturdifferenz zwischen Zuluftstrom und Abluftstrom erhöht werden, was den Wirkungsgrad der Stromerzeugungsanlage verbessert. Weiters ist es möglich, dass ein erster Teilstrom des Zuluftstroms innerhalt der Tierstallung zielgerichtet in Aufstallungen eingebracht wird und ein zweiter Teil in ein, in der Tierstallung befindliches Güllelager eingebracht wird. Damit können biologische Umwandlungsprozesse wie beispielsweise eine Fermentation der Gülle begünstigt bzw. beschleunigt werden, was zu Wärmeentwicklung führen kann und somit weiter die Temperaturdifferenz zwischen Zuluftstrom und Abluftstrom erhöhen kann.

Des Weiteren kann es zweckmäßig sein, wenn der thermoelektrische Generator mit einem Wechselrichter verbunden ist. Dabei kann weiters von Vorteil sein, wenn der Wechselrichter inselfähig ist, wobei der Wechselrichter mit einem Stromspeicher verbunden ist. Durch die elektrische Anbindung an den Wechselrichter kann die Stromerzeugungsanlage in direkter Weise an ein externes Stromnetz bzw. das lokale Stromnetz eines Betriebes mit dieser Stromerzeugungsanlage genutzt werden. Weiters ergibt sich der synergetische Vorteil, dass die erfindungsgemäße Stromerzeugungsanlage in den Nachtstunden im Jahresmittel eine höhere Temperaturdifferenz zwischen Zuluftstrom und Abluftstrom aufweist als in den Tagesstunden. Da andere erneuerbare Energiequellen, insbesondere Photovoltaik in den Nachstunden weniger ertragreich als in den Tagesstunden sind, kann mit der erfindungsgemäßen Stromerzeugungsanlage einen so entstehenden Versorgungsengpass überbrücken bzw. die Auslastung der an Energieerzeugungsanlagen elektrisch verbundenen Elemente, wie den Wechselrichter oder den Stromspeicher, erhöhen.

Ferner kann vorgesehen sein, dass der Frischluftraum als Frischluftkanal ausgebildet ist, wobei der Energieaustauscher-Bereich des Abluftkanals im Frischluftkanal angeordnet ist. Dabei ist vorteilhaft, dass der gesamte Frischluftstrom über den Energietaustauscher-Bereich das Abluftkanals geführt wird, und somit eine verbesserte Kühlung einer kühlen Seite der Seebeck-Effekt-Module des thermodynamischen Generators erreicht werden kann. Damit wird wiederum die Temperaturdifferenz zwischen der kühlen Seite und der warmen Seite, welche mit dem Abluftstrom fluidisch in Verbindung steht, erreicht. Damit entsteht wiederum einer verbesserte Energieausbeute bzw. ein verbesserter Ausnutzungsgrad bzw. Wirkungsgrad der Stromerzeugungsanlage.

Darüber hinaus kann vorgesehen sein, dass sich der Frischluftkanal und der Abluftkanal im Energietauscher-Bereich kreuzen. Somit kann der Frischluftstrom den Energieaustauscher-Bereich vollständig umspülen, was eine vorteilhaft Kühlung der kalten Seite der Seebeck-Effekt-Module bewirkt.

Vorteilhaft ist auch eine Ausprägung, gemäß welcher vorgesehen sein kann, dass der Frischluftkanal und der Abluftkanal im Energietauscher-Bereich parallel ausgebildet sind, wobei der Abluftkanal im Frischluftkanal angeordnet ist. Somit können der Zuluftstrom und der Abluftstrom in Gegenrichtung zueinander im Frischluftkanal und im Abluftkanal geführt werden, was entsprechend dem Gegenstrom-Wärmetauscher-Prinzip einen verbesserten Ausnutzungsgrad der Stromerzeugungsanlage bewirkt.

Gemäß einer Weiterbildung ist es möglich, dass der thermoelektrische Generator erste Wärmeleitkörper umfasst, wobei jeweils ein erster Wärmeleitkörper für eine Seebeck-Effekt-Modul-Anordnung vorgesehen ist, wobei der jeweilige erste Wärmeleitkörper an der, der zugeordneten Seebeck-Effekt-Modul-Anordnung abgewandten Fläche der wärmeleitfähigen Wandung ausgebildet ist, wobei der jeweilige erste Wärmeleitkörper mit der zugeordneten Seebeck-Effekt-Modul-Anordnung wärmeleitend verbunden ist. Damit wird die Wärmeübertragung zwischen dem Luftstrom und der wärmeleitfähigen Wandung verbessert. In weiterer Folge wird dadurch die ausnutzbare Temperaturdifferenz zwischen dem Zuluftstrom und dem Abluftstrom verbessert.

Ferner kann es zweckmäßig sein, wenn jede Seebeck-Effekt-Modul-Anordnung des thermoelektrischen Generators an seiner, der wärmeleitfähigen Wandung abgewandten Seite einen zweiten Wärmeleitkörper umfasst, wobei der jeweilige zweite Wärmeleitkörper mit der jeweiligen Seebeck-Effekt-Modul-Anordnung wärmeleitend gekoppelt ist. Dabei ist vorteilhaft, dass der Ausnutzungsgrad der Stromerzeugungsanlage bezüglich der nutzbaren Temperaturdifferenz zwischen dem Zuluftstrom und dem Abluftstrom erhöht werden kann.

Insbesondere kann es vorteilhaft sein, wenn die ersten und/oder die zweiten Wärmeleitkörper als Kühlrippen ausgebildet sind, wobei die jeweiligen Kühlrippen in Strömungsrichtung des Abluftstroms bzw. des Zuluftstroms ausgerichtet sind. Damit wird der Ausnutzungsgrad der Stromerzeugungsanlage bezüglich der nutzbaren Temperaturdifferenz zwischen dem Zuluftstrom und dem Abluftstrom erhöht.

Es kann weiters denkbar vorteilhaft sein, wenn jedem Seebeck-Effekt-Modul des thermoelektrischen Generators jeweils ein erster Wärmeleitkörper und ein zweiter Wärmeleitkörper zugeordnet ist, wobei eine Seebeck-Effekt-Modul-Anordnung aus entlang des Umfangs des Abluftkanals angeordneten Seebeck-Effekt-Modulen ausgebildet ist, wobei der thermoelektrische Generator mehrere Seebeck-Effekt-Modul-Anordnungen umfasst, wobei die Seebeck-Effekt-Modul-Anordnungen zueinander in Umfangrichtung versetzt angeordnet sind. Dabei ist vorteilhaft, dass mittels der Wärmeleitkörper eine Verwirbelung des Zuluftstroms bzw. des Abluftstroms induziert wird, was eine verbesserte konvektive Wärmeübertragung bewirkt und in weiterer Folge den Ausnutzungsgrad der Stromerzeugungsanlage bezüglich der nutzbaren Temperaturdifferenz zwischen dem Zuluftstrom und dem Abluftstrom erhöht.

Darüber hinaus kann vorgesehen sein, dass die Wärmeleitkörper bezüglich der Strömungsrichtung des Abluftstroms bzw. des Zuluftstroms in einem Winkel von 1° bis 30°, insbesondere in einem Winkel von 15° zur Strömungsrichtung geneigt sind. Dabei ist vorteilhaft, dass die Turbulenz des Abluftstroms bzw. des Zuluftstroms durch einen induzierten Drall der Strömungen erhöht wird und damit der Ausnutzungsgrad der Stromerzeugungsanlage bezüglich der nutzbaren Temperaturdifferenz zwischen dem Zuluftstrom und dem Abluftstrom erhöht werden kann.

Darüber hinaus kann vorgesehen sein, dass die Seebeck-Effekt-Modul-Anordnung an einer Außenfläche der wärmeleitfähigen Wandung angeordnet ist, wobei die Innenfläche der wärmeleitfähigen Wandung mit dem Abluftstrom kontaktierbar ist. Damit können die Seebeck-Effekt-Module gegenüber korrodierender Partikel im Abluftstrom geschützt werden, da die Seebeck-Effekt-Module nur mit dem Zuluftstrom direkt in Verbindung kommen. Damit wird die Langzeitstabilität der Seebeck-Effekt-Module verbessert und der Ausnutzungsgrad der Stromerzeugungsanlage über dessen Lebensdauer erhöht.

Gemäß einer besonderen Ausprägung ist es möglich, dass der Abluftkanal im Energieaustauscher-Bereich aus einem ersten Teilkanal und einem zweiten Teilkanal ausgebildet ist, wobei der erste Teilkanal und der zweite Teilkanal mittels einem ersten Übergangsstück in den Einlassbereich und mittels einem zweiten Übergangsstück in einen Auslassbereich des Abluftkanals münden, wobei der erste Teilkanal und der zweite Teilkanal jeweils einen thermoelektrischen Generator umfasst. Vorteilhaft ist dabei, dass die vom Zuluftstrom umströmte Oberfläche erhöht ist, was eine verbesserte konvektive Wärmeübertragung bewirkt und in weiterer Folge den Ausnutzungsgrad der Stromerzeugungsanlage bezüglich der nutzbaren Temperaturdifferenz zwischen dem Zuluftstrom und dem Abluftstrom erhöht.

Zum besseren Verständnis der Erfindung wird diese anhand der nachfolgenden Figuren näher erläutert.

Es zeigen jeweils in stark vereinfachter, schematischer Darstellung:
- Fig. 1: eine Stromerzeugungsanlage zur Abwärmenutzung einer Tierstallung;
- Fig. 2: eine mögliche Ausgestaltungsform des thermoelektrischen Generators in zwei verschiedenen Ansichten;
- Fig. 3: eine mögliche erste Ausgestaltungsform eines Abluft- und eines Frischluftkanals mit einem thermoelektrischen Generator;
- Fig. 4: eine mögliche zweite Ausgestaltungsform des Abluftkanals und des Frischluftkanals mit einem thermoelektrischen Generator;
- Fig. 5: eine mögliche Ausgestaltungsform des Energieaustauscher-Bereichs des Abluftkanals.

Einführend sei festgehalten, dass in den unterschiedlich beschriebenen Ausführungsformen gleiche Teile mit gleichen Bezugszeichen bzw. gleichen Bauteilbezeichnungen versehen werden, wobei die in der gesamten Beschreibung enthaltenen Offenbarungen sinngemäß auf gleiche Teile mit gleichen Bezugszeichen bzw. gleichen Bauteilbezeichnungen übertragen werden können. Auch sind die in der Beschreibung gewählten Lageangaben, wie z.B. oben, unten, seitlich usw. auf die unmittelbar beschriebene sowie dargestellte Figur bezogen und sind diese Lageangaben bei einer Lageänderung sinngemäß auf die neue Lage zu übertragen.

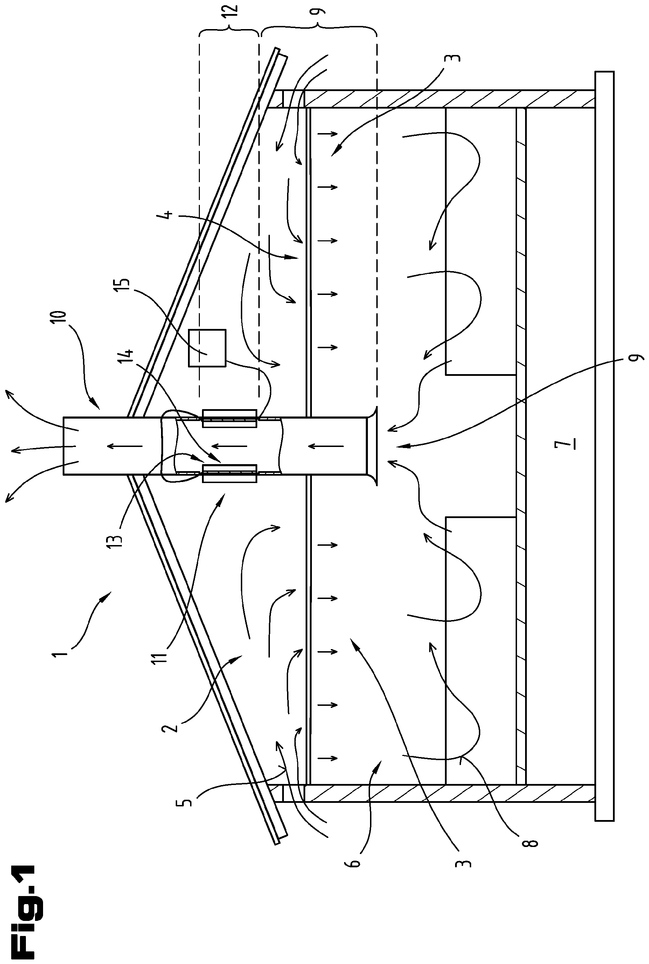

In Fig. 1 ist eine Stromerzeugungsanlage 1 zur Abwärmenutzung einer Tierstallung in vereinfachter schematischer Darstellung gezeigt. Die Stromerzeugungsanlage 1 kann einen Frischluftraum 2 umfassen, über welchen Frischluftraum 2 mittels Zuluftkanäle 3 durch eine Zuluftdecke 4 ein Zuluftstrom 5 in eine Tierstallung 6 bzw. in einen Raum, welcher eine Tierstallung 6 oder Aufstallungen umfasst, einbringbar ist. Die Tierstallung 6 kann ein Güllelager 7 umfassen. Vom Zuluftstrom 5 kann Wärme aus der Tierstallung 6 aufgenommen werden. Die Wärme in der Tierstallung 6 kann durch Tierhaltung in Aufstallungen aber auch durch Fermentationsprozesse oder andere biologische oder chemische Umwandlungsprozesse im Güllelager 7 entstehen. Der erwärmte Zuluftstrom 5 kann als Abluftstrom 8 über einen Einlassbereich 9 durch einen Abluftkanal 10 in die äußere Umgebung der Stromerzeugungsanlage 1 abgeführt werden. Durch die Aufnahme von Wärme in der Tierstallung 6 resultiert zwischen dem Zuluftstrom 5 und dem Abluftstrom 8 eine Temperaturdifferenz, welche Temperaturdifferenz je nach thermodynamischem Zustand der äußeren Umgebung und damit des Zuluftstroms 5 in einem Bereich zwischen 50 K und 5 K liegen kann.

Der Abluftkanal 10 kann einen thermodynamischen Generator 11 umfassen, welcher thermoelektrische Generator 11 in einem Energieaustauscher-Bereich 12 angeordnet ist und mit dem Abluftkanal 10 wärmeleitend verbunden ist. Der thermoelektrische Generator 11 kann eine Seebeck-Effekt-Modul-Anordnung 13 aufweisen, welche einzelne Seebeck-Effekt-Module 14 umfassen kann. Je nach Ausgestaltung der Seebeck-Effekt-Module 14 können diese elektrisch seriell oder parallel miteinander verbunden sein, und somit die Seebeck-Effekt-Modul-Anordnung 13 ausbilden. Nach dem physikalischen Seebeck-Effekt kann mittels einem Seebeck-Effekt-Modul 14 durch eine Temperaturdifferenz eine Thermospannung generiert werden. Je nach elektrischer Verschaltung der einzelnen Seebeck-Effekt-Module 14 kann in weiterer Folge eine bestimmungsgemäß gewünschte Stromstärke und Spannung der Seebeck-Effekt-Modul-Anordnung 13 von einem, an die Seebeck-Effekt-Modul-Anordnung 13 verbundenen elektrischen Verbraucher verwertet werden. Eine Seebeck-Effekt-Modul-Anordnung 13 kann somit eine Vielzahl von Seebeck-Effekt-Modulen 14 in elektrischer Reihen- oder Parallelschaltung umfassen. Der thermoelektrische Generator 11 kann weiters eine oder mehrere Seebeck-Effekt-Modul-Anordnungen 13, sowie weitere elektronische Bauteile zur Spannungs- und Stromstärkenregulierung umfassen. Der elektrische Verbraucher kann ein Wechselrichter 15 sein, welcher Wechselrichter weiters mit einem elektrischen Versorgungsnetz und mit einem Stromspeicher elektrisch verbunden sein kann.

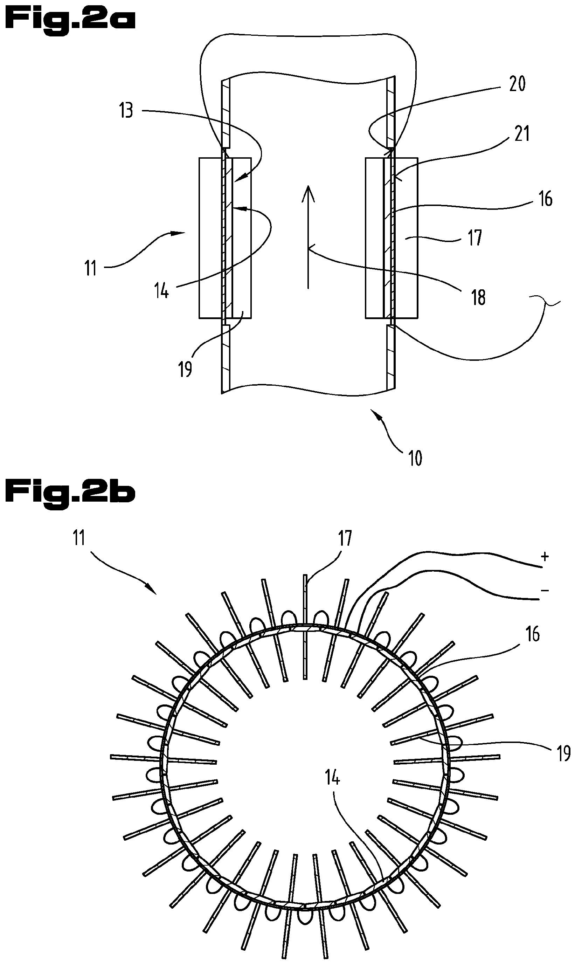

In Fig. 2 ist eine mögliche Ausgestaltungsform des thermoelektrischen Generators 11 in zwei verschiedenen Ansichten dargestellt. Fig. 2a zeigt den thermoelektrischen Generator 11 im Aufriss. Der thermoelektrische Generator 11 kann eine wärmeleitfähige Wandung 16, eine Seebeck-Effekt-Modul-Anordnung 13 mit Seebeck-Effekt-Modulen 14 und erste Wärmeleitkörper 17 umfassen. Die ersten Wärmeleitkörper 17 können als Kühlrippen ausgebildet sein. Es kann vorgesehen sein, dass eine Seebeck-Effekt-Modul-Anordnung 13 derart aus Seebeck-Effekt-Modulen 14 aufgebaut ist, dass die einzelne Seebeck-Effekt-Modulen 14 einer Seebeck-Effekt-Modul-Anordnung 13 aufeinanderfolgend in Richtung entlang einer Durchströmrichtung 18 des Abluftkanals 10 angeordnet sind. Weiters kann jeweils einer Seebeck-Effekt-Modul-Anordnung 13 ein erster Wärmeleitkörper 17 zugeordnet sein, wobei der jeweilige erste Wärmeleitkörper 17 auf der, der jeweiligen Seebeck-Effekt-Modul-Anordnung 13 abgewandten Seite der wärmeleitfähigen Wandung 16 ausgebildet ist. Der jeweilige erste Wärmeleitkörper 17 kann mit der zugeordneten Seebeck-Effekt-Modul-Anordnung 13 wärmeleitend verbunden sein.

Weiters kann der thermoelektrische Generator 11 zweite Wärmeleitkörper 19 umfassen, wobei jeweils ein zweiter Wärmeleitkörper 19 einer Seebeck-Effekt-Modul-Anordnung 13 zugeordnet sein kann. Die zweiten Wärmeleitkörper 19 können an der, der wärmeleitfähigen Wandung 16 abgewandten Seite der jeweiligen Seebeck-Effekt-Modul-Anordnung 13 ausgebildet sein. Ein zweiter Wärmeleitkörper 19 kann mit direkter wärmeleitfähiger Verbindung am jeweiligen Seebeck-Effekt-Modul-Anordnung 13 ausgebildet sein.

Der thermoelektrische Generator 11 umfasst eine Innenfläche 20 der wärmeleitfähigen Wandung 16 und eine Außenfläche 21 der wärmeleitfähigen Wandung 16. Es kann vorgesehen sein, dass die Seebeck-Effekt-Module 14 an der Innenfläche 20 der wärmeleitfähigen Wandung 16 angeordnet sind. Gleichermaßen ist eine Ausführungsform denkbar, bei welcher die Seebeck-Effekt-Modulen 14 an der Außenfläche 21 der wärmeleitfähigen Wandung 16 angeordnet sind. Der thermoelektrische Generator 11 kann im Frischluftraum 2 (vgl. Fig. 1) vorteilhafter Weise derart angeordnet sein, dass die ersten Wärmeleitkörper 17 vom Zuluftstrom 5 umspült werden. Gleichzeitig werden die zweiten Wärmeleitkörper 19 vom Abluftstrom 8 im Inneren des Abluftkanals 10 bzw. im Inneren des thermoelektrischen Generators 11 umspült.

Fig. 2b zeigt zur besseren Veranschaulichung die beschriebene mögliche Ausführungsform des thermoelektrischen Generators 11 im Aufriss.

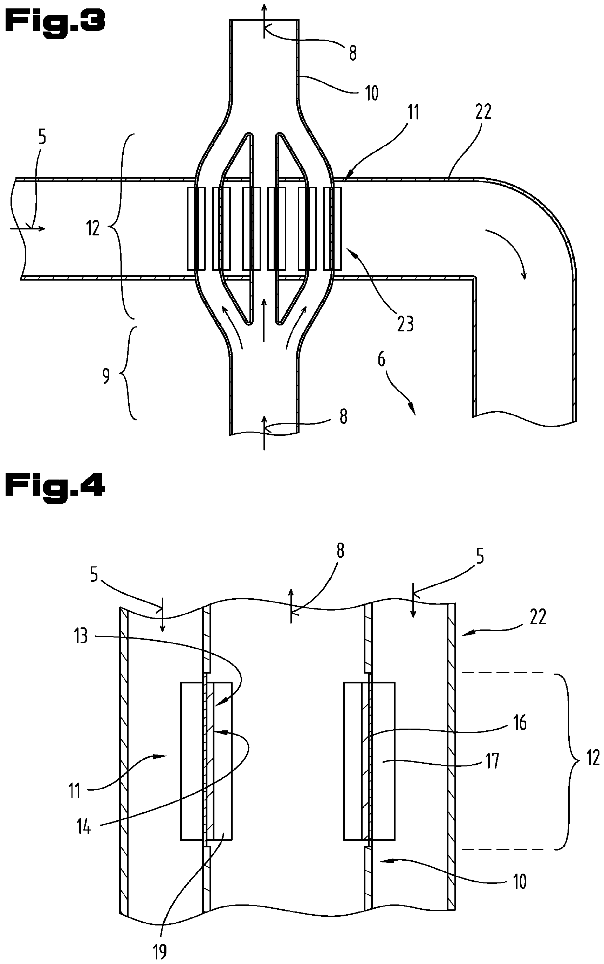

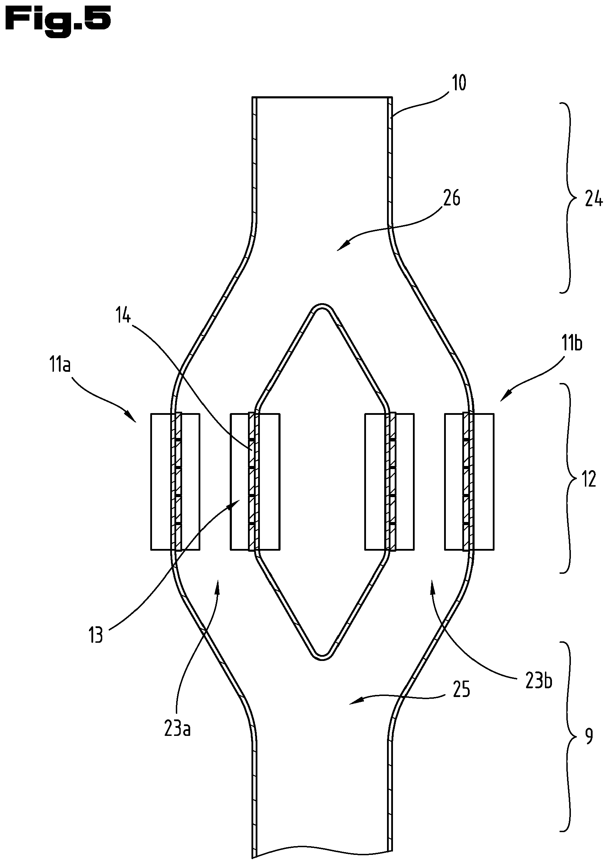

Fig. 3 zeigt eine mögliche erste Ausgestaltungsform eines Abluftkanals 10 und eines Frischluftkanals 22 mit einem thermoelektrischen Generator. Es kann vorgesehen sein, dass der Frischluftraum 2 (vgl. Fig. 1) als Frischluftkanal 22 ausgebildet ist. Damit kann erreicht werden, dass der gesamte Zuluftstrom 5 über den Energieaustauscher-Bereich 12 des Abluftkanals 10 und damit über den thermoelektrischen Generator 11 geführt wird. Im Wesentlichen kreuzen sich bei dieser Anordnung des Frischluftkanals 22 und des Abluftkanals 10 der Zuluftstrom 5 und der Abluftstrom 8. Weiters kann vorgesehen sein, dass der Abluftkanal 10 im Energieaustauscher-Bereich 12 in Teilkanäle 23 aufgefächert ist, wobei an jedem Teilkanal der Teilkanäle 23 ein thermoelektrischer Generator 11 ausgebildet ist. Vergleich dazu auch die in Fig. 5 dargestellte mögliche Ausgestaltungsform des Energieaustauscher-Bereichs 12 des Abluftkanals 10.

Fig. 4 zeigt eine mögliche zweite Ausgestaltungsform des Abluftkanals 10 und des Frischluftkanals 22 mit einem thermoelektrischen Generator 11. Dabei kann der Abluftkanals 10 zumindest im Energieaustauscher-Bereich 12 parallel zum Frischluftkanal 22 ausgerichtet sein und im Frischluftkanal 22 angeordnet sein. Der Zuluftstrom 5 und der Abluftstrom 8 sind somit auf einfache Weise im Gegenlauf zueinander führbar.

Fig. 5 zeigt eine mögliche Ausgestaltungsform des Energieaustauscher-Bereichs 12 des Abluftkanals 10. Dabei ist der Abluftkanal 10 im Energieaustauscher-Bereich 12 in Teilkanäle 23 bzw. 23a und 23b aufgefächert bzw. aufgeteilt, wobei am Übergang zum Einlassbereich 9 ein erstes Übergangsstück 25 und am Übergang zu einem Auslassbereich 24 ein zweites Übergangsstück 26 ausgebildet sind. In den Teilkanälen 23a und 23b kann jeweils ein thermoelektrischer Generator 11 bzw. 11a und 11b ausgebildet sein.

Die Ausführungsbeispiele zeigen mögliche Ausführungsvarianten, wobei an dieser Stelle bemerkt sei, dass die Erfindung nicht auf die speziell dargestellten Ausführungsvarianten derselben eingeschränkt ist, sondern vielmehr auch diverse Kombinationen der einzelnen Ausführungsvarianten untereinander möglich sind und diese Variationsmöglichkeit aufgrund der Lehre zum technischen Handeln durch gegenständliche Erfindung im Können des auf diesem technischen Gebiet tätigen Fachmannes liegt.

Der Schutzbereich ist durch die Ansprüche bestimmt. Die Beschreibung und die Zeichnungen sind jedoch zur Auslegung der Ansprüche heranzuziehen. Einzelmerkmale oder Merkmalskombinationen aus den gezeigten und beschriebenen unterschiedlichen Ausführungsbeispielen können für sich eigenständige erfinderische Lösungen darstellen. Die den eigenständigen erfinderischen Lösungen zugrundeliegende Aufgabe kann der Beschreibung entnommen werden.

Sämtliche Angaben zu Wertebereichen in gegenständlicher Beschreibung sind so zu verstehen, dass diese beliebige und alle Teilbereiche daraus mitumfassen, z.B. ist die Angabe 1 bis 10 so zu verstehen, dass sämtliche Teilbereiche, ausgehend von der unteren Grenze 1 und der oberen Grenze 10 mit umfasst sind, d.h. sämtliche Teilbereiche beginnen mit einer unteren Grenze von 1 oder größer und enden bei einer oberen Grenze von 10 oder weniger, z.B. 1 bis 1,7, oder 3,2 bis 8,1, oder 5,5 bis 10.

Der Ordnung halber sei abschließend darauf hingewiesen, dass zum besseren Verständnis des Aufbaus Elemente teilweise unmaßstäblich und/oder vergrößert und/oder verkleinert dargestellt wurden.

### Bezugszeichenaufstellung

- 1: Stromerzeugungsanlage
- 2: Frischluftraum
- 3: Zuluftkanäle
- 4: Zuluftdecke
- 5: Zuluftstrom
- 6: Tierstallung
- 7: Güllelager
- 8: Abluftstrom
- 9: Einlassbereich
- 10: Abluftkanal
- 11: thermoelektrischer Generator
- 12: Energieaustauscher-Bereich
- 13: Seebeck-Effekt-Modul-Anordnung
- 14: Seebeck-Effekt-Modul
- 15: Wechselrichter
- 16: wärmeleitfähige Wandung
- 17: erste Wärmeleitkörper
- 18: Durchströmrichtung
- 19: zweite Wärmeleitkörper
- 20: Innenfläche der wärmeleitfähigen Wandung
- 21: Außenfläche der wärmeleitfähigen Wandung
- 22: Frischluftkanal
- 23: Teilkanäle des Abluftkanals
- 24: Auslassbereich
- 25: erstes Übergangsstück
- 26: zweites Übergangsstück

## Patentansprüche

1. Stromerzeugungsanlage (1) zur Abwärmenutzung einer Tierstallung (6) umfassend einen Frischluftraum (2) und einen Abluftkanal (10), der Abluftkanal (10) umfassend einen Einlassbereich (9) und einen Energieaustauscher-Bereich (12), wobei mittels dem Einlassbereich (9) des Abluftkanals (10) ein Abluftstrom (8) aus der Tierstallung (6) entnehmbar ist und über den Energieaustauscher-Bereich (12) in eine äußere Umgebung abführbar ist, **dadurch gekennzeichnet, dass**
- der Energieaustauscher-Bereich (12) des Abluftkanals (10) im Frischluftraum (2) angeordnet ist, wobei ein Zuluftstrom (5) über den Frischluftraum (2) mittels Zuluftkanälen (3) in die Tierstallung (6) einbringbar ist;
- der Abluftkanal (10) im Energieaustauscher-Bereich (12) einen thermoelektrischen Generator (11) umfasst, welcher thermoelektrische Generator (11) eine wärmeleitfähige Wandung (16) und eine Thermoelektrizitäts-Modulanordnung, insbesondere eine Seebeck-Effekt-Modul-Anordnung (13), umfasst, welche einzelne Seebeck-Effekt-Module (14) umfasst, mittels welcher Seebeck-Effekt-Module (14) durch eine Temperaturdifferenz zwischen dem Zuluftstrom (5) und dem Abluftstrom (8) elektrische Energie generierbar ist.

2. Stromerzeugungsanlage (1) nach Anspruch 1, **dadurch gekennzeichnet, dass** der thermoelektrische Generator (11) mit einem Wechselrichter (15) verbunden ist.

3. Stromerzeugungsanlage (1) nach einem der vorhergehenden Ansprüche, **dadurch gekennzeichnet, dass** der Frischluftraum (2) als Frischluftkanal (22) ausgebildet ist, wobei der Energieaustauscher-Bereich (12) des Abluftkanals (10) im Frischluftkanal (22) angeordnet ist.

4. Stromerzeugungsanlage (1) nach einem der vorhergehenden Ansprüche, **dadurch gekennzeichnet**, nach vorher, dass sich der Frischluftkanal (22) und der Abluftkanal (10) im Energietauscher-Bereich kreuzen.

5. Stromerzeugungsanlage (1) nach Anspruch 4, **dadurch gekennzeichnet, dass** der Frischluftkanal (22) und der Abluftkanal (10) im Energietauscher-Bereich parallel ausgebildet sind, wobei der Abluftkanal (10) im Frischluftkanal (22) angeordnet ist.

6. Stromerzeugungsanlage (1) nach einem der vorhergehenden Ansprüche, **dadurch gekennzeichnet, dass** der thermoelektrische Generator (11) erste Wärmeleitkörper (17) umfasst, wobei jeweils ein erster Wärmeleitkörper (17) für eine Seebeck-Effekt-Modul-Anordnung (13) vorgesehen ist, wobei der jeweilige erste Wärmeleitkörper (17) an der, der zugeordneten Seebeck-Effekt-Modul-Anordnung (13) abgewandten Fläche der wärmeleitfähigen Wandung (16) ausgebildet ist, wobei der jeweilige erste Wärmeleitkörper (17) mit der zugeordneten Seebeck-Effekt-Modul-Anordnung (13) wärmeleitend verbunden ist.

7. Stromerzeugungsanlage (1) nach einem der vorhergehenden Ansprüche, **dadurch gekennzeichnet, dass** jede Seebeck-Effekt-Modul-Anordnung (13) des thermoelektrischen Generators (11) an seiner, der wärmeleitfähigen Wandung (16) abgewandten Seite einen zweiten Wärmeleitkörper (19) umfasst, wobei der jeweilige zweite Wärmeleitkörper (19) mit der jeweiligen Seebeck-Effekt-Modul-Anordnung (13) wärmeleitend gekoppelt ist.

8. Stromerzeugungsanlage (1) nach einem der vorhergehenden Ansprüche, **dadurch gekennzeichnet, dass** die Seebeck-Effekt-Modul-Anordnung (13) an einer Innenfläche (20) der wärmeleitfähigen Wandung (16) angeordnet ist.

9. Stromerzeugungsanlage (1) nach einem der vorhergehenden Ansprüche, **dadurch gekennzeichnet, dass** die Seebeck-Effekt-Modul-Anordnung (13) an einer Außenfläche (21) der wärmeleitfähigen Wandung (16) angeordnet ist, wobei die Innenfläche (20) der wärmeleitfähigen Wandung (16) mit dem Abluftstrom (8) kontaktierbar ist.

10. Stromerzeugungsanlage (1) nach einem der vorhergehenden Ansprüche, **dadurch gekennzeichnet, dass** der Abluftkanal (10) im Energieaustauscher-Bereich (12) aus einem ersten Teilkanal und einem zweiten Teilkanal ausgebildet ist, wobei der erste Teilkanal und der zweite Teilkanal mittels einem ersten Übergangsstück in den Einlassbereich (9) und mittels einem zweiten Übergangsstück in einen Auslassbereich des Abluftkanals (10) münden, wobei der erste Teilkanal und der zweite Teilkanal jeweils einen thermoelektrischen Generator (11) umfasst.
